# EUROPEAN PATENT SPECIFICATION

(11) **EP 3 001 775 B1**
(45) Date of publication and mention of the grant of the patent: **31.01.2018**
(21) Application number: 14801506.8
(22) Date of filing: 19.05.2014
(51) Int. Cl.: H05B 6/12, H05K 7/20, H01L 23/13, H01L 23/367, H01L 23/373, H01L 23/40

(54) **INDUCTION HEATING COOKER**
INDUKTIONSHERD
CUISINIÈRE À CHAUFFAGE PAR INDUCTION

(30) Priority: 21.05.2013 JP 2013106865
(43) Date of publication of application: 30.03.2016
(73) Proprietor: Panasonic Intellectual Property Management Co., Ltd., Osaka-shi, Osaka 540-6207 (JP)
(72) Inventor: KOMOTO, Hirofumi, Osaka 540-6207 (JP); YAMAMOTO, Yuji, Osaka 540-6207 (JP)
(74) Representative: Eisenführ Speiser
(86) International application number: PCT/JP2014/002626
(87) International publication number: WO 2014/188698

(56) References cited:
- JP-A- H07 212 059
- JP-A- 2003 283 171
- JP-A- 2006 135 169
- JP-A- 2011 014 261
- JP-A- 2011 014 261
- JP-A- 2011 258 368
- JP-A- 2013 084 675
- JP-A- 2013 084 675
- US-A1- 2010 044 367

## Description

### TECHNICAL FIELD

The present invention relates to an induction heating cooker used in, for example, a kitchen of an ordinary home, and more specifically to a structure for cooling a switching device included in an inverter circuit which supplies high frequency current to a heating coil in the induction heating cooker.

### BACKGROUND ART

Conventionally, an apparatus of such kind of induction heating cooker is known, for example, such as that disclosed in Patent Document 1. As shown in Fig. 5, the induction heating cooker disclosed in Patent Document 1 is provided with a radiator 32 for cooling a switching device 31. The radiator 32 has a recess having a flat surface part on which the switching device 31 is fixed. In order to fix the switching device 31 to the flat surface part of the radiator 32, a screw is used. Bending process is applied to a lead portion of the switching device 31 to bend the lead portion in an "L" shape such that the lead portion extends perpendicularly to a printed wiring board 33, and the lead portion penetrates the printed wiring board 33. A penetrating part of the lead portion is fixed to the printed wiring board 33 by soldering.

Patent Document 2 describes an arrangement of circuit board, power devices, cooler and wiring similar to the arrangement according to the present teaching. However, the disclosure of Patent Document 2 does not relate to an induction heating cooker.

### Prior Art Documents

### Patent Documents

Patent Document 1: JP 2011-14261 A
Patent Document 2: JP 2013-084675 A

### SUMMARY OF INVENTION

### TECHNICAL PROBLEM

However, in the above-mentioned conventional induction heating cooker, the distance h between the flat surface part of the radiator 32 and the printed wiring board 33 has to be at least longer than a total length of the thickness of the switching device 31 and the height of a screw head of the screw for fixing the switching device 31. On the other hand, in order to enhance the cooling efficiency of the switching device 31, the height of radiation fins of the radiator 32 needs be made high. Therefore, according to the configuration of the radiator of the conventional induction heating cooker, since the distance between the lower surface of the printed wiring board 33 and the upper surface of the radiator 32 is long, the induction heating cooker needs to be large. Therefore, there was a problem that it was difficult to achieve both ensuring the height of the radiation fins for improving the cooling efficiency of the switching device 31 and downsizing the induction heating cooker.

An object of the present invention is to solve the above-mentioned problem and to provide an induction heating cooker capable of achieving both an improvement of the cooling efficiency of a switching device and a downsizing of the induction heating cooker.

### SOLUTION TO PROBLEM

In order to solve the problem of the conventional art, the present invention provides a configuration including:
a heating coil;
an inverter circuit having a switching device, the inverter circuit performing on-off control of the switching device to supply high frequency current to the heating coil;
a radiator having a mounting surface on which the switching device is mounted; and
a printed wiring board on which components included in the inverter circuit are arranged, wherein
the radiator is mounted on a surface on one side of the printed wiring board,
the printed wiring board has an opening larger than a main body of the switching device,
the main body being a part of the switching device excluding a lead portion of the switching device,
the switching device is mounted on the mounting surface of the radiator through the opening of the printed wiring board, and
the lead portion comprises
   an extending part which linearly extends from the main body of the switching device in a direction substantially parallel to the mounting surface of the radiator,
   a projecting part which extends and projects in a direction away from the mounting surface of the radiator beyond a root of the lead portion on the main body of the switching device and beyond another surface on the other side of the printed wiring board different from the surface on the one side of the printed wiring board, and
   an inclined-and-extending part which is inclined at a predetermined inclination angle relative to the other surface of the printed wiring board and extends from a projecting end of the projecting part to the other surface of the printed wiring board.

According to the above configuration, since the switching device is mounted on the mounting surface of the radiator through the opening of the printed wiring board, the mounting surface, which is a contact surface between the switching device and the radiator, can be provided at a position close to the printed wiring board, and the height of radiation fins of the radiator can be ensured in a limited space.

### EFFECTS OF INVENTION

According to the induction heating cooker of the present invention, the switching device is mounted on the mounting surface of the radiator through the opening of the printed wiring board. Therefore, the mounting surface, which is a contact surface between the switching device and the radiator, can be provided at a position close to the printed wiring board. Therefore, the distance between another surface on the other side of the printed wiring board different from the surface on the one side of the printed wiring board and a surface on an opposite side of the mounting surface of the radiator can be shortened, and the induction heating cooker can be downsized. In addition, since the height of the radiation fins of the radiator can be secured in a space for the cooling, the heat radiation efficiency is improved. Therefore, an induction heating cooker can be provided that achieves both an improvement of the cooling efficiency of the switching device and a downsizing of the induction heating cooker.

### BRIEF DESCRIPTION OF DRAWINGS

Fig. 1 is a circuit diagram of an induction heating cooker according to a first embodiment of the present invention.
Fig. 2A and Fig. 2B are a longitudinal sectional view showing a neighborhood of a switching device and a perspective view of a radiator in the induction heating cooker according to the first embodiment of the present invention, respectively.
Fig. 3 is a longitudinal sectional view showing an example of a lead portion of the switching device according to a modified example of the first embodiment.
Fig. 4 is a longitudinal sectional view showing a neighborhood of the switching device in the induction heating cooker according to a second embodiment of the invention.

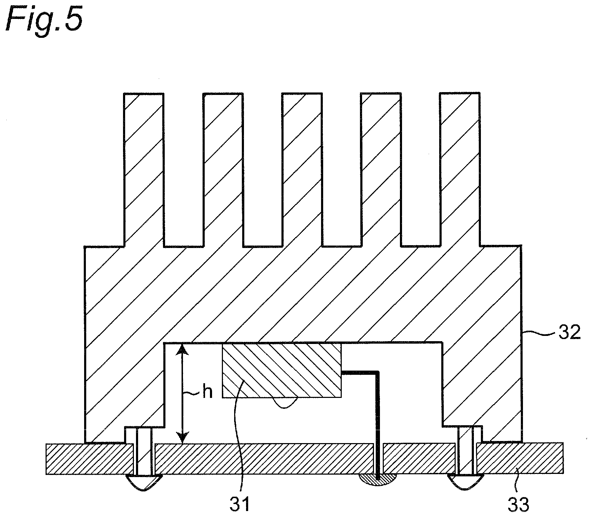

Fig. 5 is a longitudinal sectional view showing a neighborhood of the switching device of a conventional induction heating cooker.

### DESCRIPTION OF EMBODIMENTS

A first invention provides a configuration including:
a heating coil;
an inverter circuit having a switching device, the inverter circuit performing on-off control of the switching device to supply high frequency current to the heating coil;
a radiator having a mounting surface on which the switching device is mounted; and
a printed wiring board on which components included in the inverter circuit are arranged, wherein
the radiator is mounted on a surface on one side of the printed wiring board,
the printed wiring board has an opening larger than a main body of the switching device, the main body being a part of the switching device excluding a lead portion of the switching device,
the switching device is mounted on the mounting surface of the radiator through the opening of the printed wiring board, and the lead portion comprises
   an extending part which linearly extends from the main body of the switching device in a direction substantially parallel to the mounting surface of the radiator,
   a projecting part which extends and projects in a direction away from the mounting surface of the radiator beyond a root of the lead portion on the main body of the switching device and beyond another surface on the other side of the printed wiring board different from the surface on the one side of the printed wiring board, and
   an inclined-and-extending part which is inclined at a predetermined inclination angle relative to the other surface of the printed wiring board and extends from a projecting end of the projecting part to the other surface of the printed wiring board.

According to the above configuration, the switching device is mounted on the mounting surface of the radiator through the opening of the printed wiring board. Therefore, the mounting surface of the radiator, which is a contact surface between the switching device and the radiator, can be provided at a position close to the printed wiring board. Therefore, the distance between a lower surface of the printed wiring board and an upper surface of the radiator can be shortened, and the induction heating cooker can be downsized. In addition, since the height of radiation fins of the radiator can be ensured in a space for the cooling, heat radiation efficiency is improved. Therefore, an improvement of the cooling efficiency of the switching device and a downsizing of the induction heating cooker can be achieved.

According to the above configuration, since the lead portion includes the projecting part and the inclined-and-extending part which are formed by bending process applied to the lead portion, the lead portion can be connected by soldering with a wiring pattern formed on the other surface of the printed wiring board. Therefore, thermal stress occurring in a joining portion between the switching device and the wiring pattern on the printed wiring board can be reduced, and thus occurrence of solder cracking at the joining portion can be prevented. Therefore, reliability against the solder cracking can be improved. Further, the inclined-and-extending part in the lead portion of the switching device is inclined at a predetermined inclination angle relative to the other surface of the printed wiring board. Therefore, when the lead portion is soldered to the copper foil pattern, the solder easily enters between the lead portion of the switching device and the wiring pattern of the printed wiring board. Therefore, soldering can be made with good quality, without using a conventional penetrating lead configuration that makes a lead portion penetrate the printed wiring board.

A second invention provides a configuration, in particular, in the first invention, wherein
a fixing-and-supporting member for fixing the radiator to the printed wiring board and supporting the radiator is attached to the radiator such that a part of the fixing-and-supporting member projects from the mounting surface of the radiator,
the printed wiring board has a mounting hole formed for allowing the fixing-and-supporting member to penetrate the mounting hole when the radiator is mounted to the printed wiring board, and
an end part of the fixing-and-supporting member is fixed by soldering to the other surface of the printed wiring board in a state that the fixing-and-supporting member penetrates the mounting hole.

According to the above configuration, the radiator does not need to have a screw hole provided thereon with which a screw is engaged for fixing the radiator to the printed wiring board. Therefore, no space for providing such a screw hole needs to be provided in the radiator. This allows the number of the radiation fins of the radiator to be increased, or this enhances the flexibility of arrangement of the radiation fins, thereby enabling the cooling effect of the radiation fins to be increased. Therefore, the cooling efficiency of the switching device can be improved.

A third invention provides a configuration, in particular, in the second invention, further including
an eyelet attached to the mounting hole of the printed wiring board, the eyelet being formed such that the fixing-and-supporting member fits into the eyelet.

Therefore, the fixing-and-supporting member is securely fixed to the mounting hole of the printed wiring board by the eyelet. This means that the radiator can be more securely fixed to the printed wiring board. Therefore, even when an impact is given, for example, to the printed wiring board or the radiator, occurrence of displacement between the printed wiring board and the radiator is suppressed. Therefore, a load applied to the lead portion of the switching device can be reduced. Therefore, the configuration according to the third invention can be easily realized.

A fourth invention provides a configuration, in particular, in the second or third invention, wherein
the radiator further includes
radiation fins including a plurality of plates formed parallel to each other, each of the radiation fins having a fin-shape extending in a direction parallel to the mounting surface, and
a slot formed on the mounting surface such that the slot extends in the direction parallel to the mounting surface.

Therefore, since the slot can be formed simultaneously with the manufacture of the radiator by the extrusion molding process, the radiator having the slot can be manufactured easily and at a low cost.

A fifth invention provides a configuration, in particular, in any one of the second to fourth inventions,
the radiator has a hook part formed on one end thereof for hooking and seizing the printed wiring board such that an edge portion of the printed wiring board comes into contact with the hook part, and
the radiator is fixed, at another end different from the one end of the radiator, to the printed wiring board by the fixing-and-supporting member.

According to the above configuration, the printed wiring board and the radiator can be more securely fixed by the use of a simple configuration of the radiator. Therefore, even when an impact is applied, for example, to the printed wiring board or the radiator, occurrence of displacement between the printed wiring board and the radiator is suppressed. Therefore, a load applied to the lead portion of the switching device can be reduced. Therefore, the configurations according to the third to fifth inventions can be easily realized.

### First Embodiment

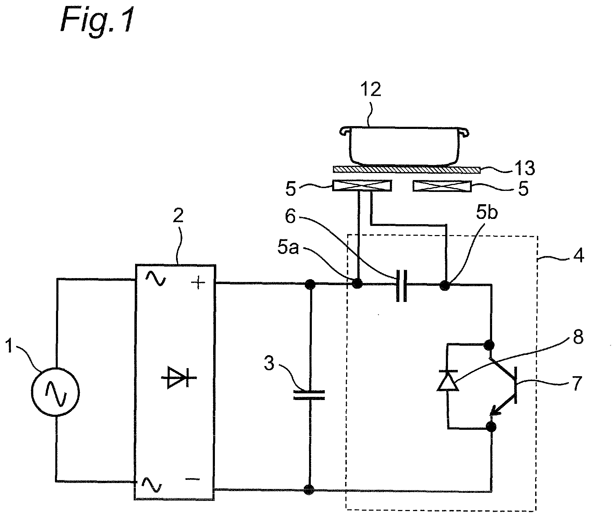

Fig. 1 is a circuit diagram of an induction heating cooker according to a first embodiment of the present invention. In Fig. 1, the induction heating cooker includes a rectifier circuit 2, a smoothing capacitor 3, an inverter circuit 4, and a heating coil 5. The heating cooker further includes a top plate 13 which is, for example, made of glass. The top plate 13 is placed on the heating coil 5. An object 12 to be heated, such as a pan, is placed on the top plate 13 by a user. When the inverter circuit 4 supplies alternating current (AC) with high frequency to the heating coil 5 and makes the heating coil 5 generate alternating magnetic field, induction heating is applied to the object 12 to be heated.

In Fig. 1, commercial power source 1 supplies electric power to the induction heating cooker. The rectifier circuit 2 performs full-wave rectification of AC voltage from the commercial power source 1. The smoothing capacitor 3 smooths the direct current (DC) voltage outputted from the rectifier circuit 2. The commercial power source 1, the rectifier circuit 2, and the smoothing capacitor 3 constitute a DC power supply as a whole.

The inverter circuit 4 includes a resonance capacitor 6, a switching device 7, and a reverse conducting diode 8 connected in reversely parallel to the switching device 7. The heating coil 5 is connected with the resonance capacitor 6 via connecting terminals 5a and 5b. When the switching device 7 is controlled to perform on-off operation, high frequency current is supplied to the heating coil 5.

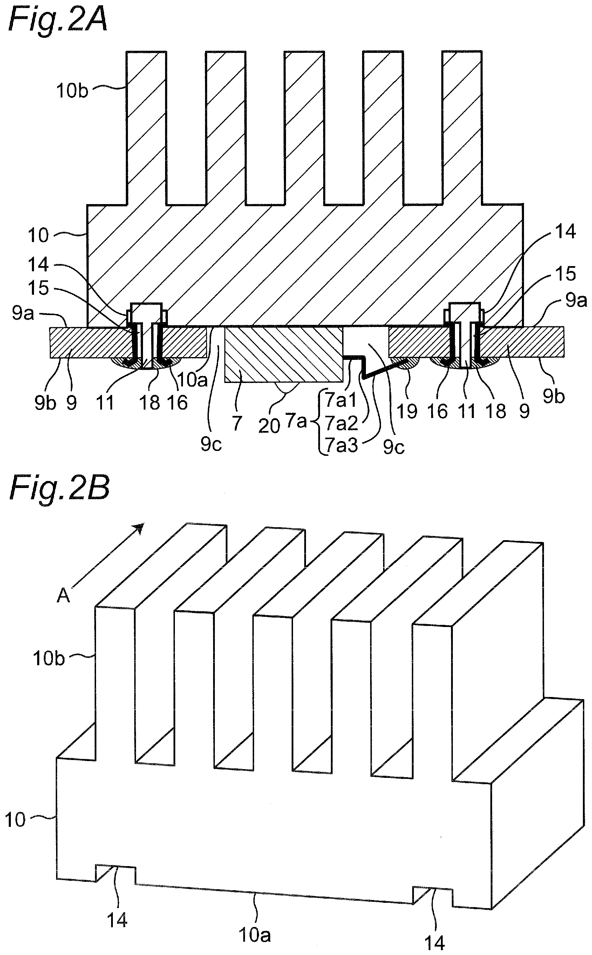

During the operation, the switching device 7 generates heat. Therefore, a radiator is mounted on a printed wiring board, which radiates heat generated by the switching device 7. With reference to Fig. 2A and Fig. 2B, configurations of the printed wiring board 9, the radiator 10, and the switching device 7 are described as follows.

Fig. 2A is a longitudinal sectional view showing the printed wiring board 9, the switching device 7, and the radiator 10 mounted on the printed wiring board 9 in the induction heating cooker according to the first embodiment of the present invention. Each component of the rectifier circuit 2, the smoothing capacitor 3, the connecting terminals 5a and 5b for connection with the heating coil 5, and the resonance capacitor 6 described above is mounted on and fixed to the printed wiring board 9. Terminals of these components are connected by soldering with a copper foil pattern formed on a lower surface 9b of the printed wiring board 9, or on both sides of an upper surface 9a and the lower surface 9b of the printed wiring board 9. It is noted that a wiring pattern is not limited to the copper foil pattern, and the wiring pattern formed on the printed wiring board 9 may be formed by arbitrary kind of conductive foil.

Fig. 2B is a perspective view of the radiator 10 of Fig. 2A. The radiator 10 is manufactured by extrusion molding process of aluminum. More specifically, the radiator 10 is manufactured by the extrusion molding process in which aluminum is pushed out from a mold having a predetermined shape in the direction (hereinafter referred to as "extrusion direction") A indicated in Fig. 2B. The radiator 10 has a mounting surface 10a and radiation fins 10b. The mounting surface 10a is a flat surface on which the switching device 7 is mounted and fixed. The radiation fins 10b are formed on an opposite side of mounting surface 10a. The radiator 10 is mounted on the printed wiring board 9 such that the mounting surface 10a, to which the switching device 7 is fixed, faces the upper surface 9a of the printed wiring board 9. It is noted that the mounting surface 10a may have a step with a level difference between a surface area on which the switching device 7 is mounted and a surface area which contacts with the printed wiring board 9 which are two surface areas provided on a same side of the radiator 10.

As shown in Fig. 2B, the radiator 10 further has slots 14, which are formed by the extrusion molding process such that the slots 14 extend in the above-mentioned extrusion direction A parallel to the mounting surface 10a. Namely, the radiation fins 10b and slots 14 of the radiator 10 are formed simultaneously so as to extend in the same extrusion direction A to each other during the extrusion molding process of radiator 10.

As shown in Fig. 2A, the radiator 10 further includes fixing-and-supporting members 11 which are attached to the mounting surface 10a of radiator 10 such that a part (pin part) of each of the fixing-and-supporting members 11 projects from the mounting surface 10a. Each of the fixing-and-supporting members 11 includes a base part having substantially the same width as the width of the slot 14 and a pin part having a width smaller than the width of the slot 14. The fixing-and-supporting members 11 are manufactured from material suitable for soldering, such as copper, or plating process is performed on the fixing-and-supporting members 11 with such material suitable for soldering. The base parts of the fixing-and-supporting members 11 are attached and fixed to the mounting surface 10a of the radiator 10 by being securely fixed to the slot 14 in a suitable manner, such as caulking, driving, embedding, or screwing. At this time, the pin parts of the fixing-and-supporting members 11 are projected from the mounting surface 10a of radiator 10. During the assembly, the radiator 10 is first mounted on the printed wiring board 9 such that the pin parts of fixing-and-supporting members 11 penetrate the mounting holes 15 formed on the printed wiring board 9. The fixing-and-supporting members 11 are then soldered by solder 18 to the copper foil pattern on the lower surface 9b of the printed wiring board 9 to be fixed to the printed wiring board 9.

Eyelets 16 are attached to the mounting holes 15 of the printed wiring board 9. Eyelets 16 are formed so as to securely fit into the respective pin parts of the fixing-and-supporting members 11 with a physical fixation. When the fixing-and-supporting members 11 penetrate the mounting holes 15 of the printed wiring board 9, the fixing-and-supporting members 11 also penetrate the eyelets 16. Therefore, the eyelets 16 make the physical connection between the printed wiring board 9 and the fixing-and-supporting members 11 of radiator 10 more secure. Therefore, although the radiator 10 may have a heavy weight, a movement of the radiator 10 relative to the printed wiring board 9, for example, due to vibration is suppressed. As a result, this enhances reliability of the joining portion by the solder 19 between the lead portion 7a of the switching device 7 and the copper foil pattern.

The reverse conducting diode 8 is implemented in the same package as the switching device 7. The printed wiring board 9 has an opening 9c which is larger than a package main body (hereinafter referred to as "main body") of the switching device 7 such that the opening 9c at least does not contact with the main body of the switching device 7. In this case, the main body is a part of the switching device 7 excluding the lead portion 7a of the switching device 7. Therefore, in a state that the radiator 10 is mounted on the printed wiring board 9, some part of the mounting surface 10a of the radiator 10 is exposed outside via the opening 9c of the printed wiring board 9. The main body of switching device 7 is mounted on the mounting surface 10a of the radiator 10 through the opening 9c of the printed wiring board 9 and fixed to the mounting surface 10a with a screw 20. When the switching device 7 is attached to the radiator 10, heat transfer compound such as a silicon compound is thinly applied to the mounting surface 10a of the radiator 10 or to a surface (hereinafter referred to as "upper surface") of the switching device 7 which faces the mounting surface 10a of the radiator 10. The heat transfer suppresses occurrence of an air layer between the switching device 7 and the radiator 10 which may be caused by, for example, influence of variation in the flatness of the mounting surface 10a of the radiator 10 and that of the upper surface of the switching device 7. As a result, deterioration of thermal conductivity between the switching device 7 and the radiator 10 can be suppressed.

The lead portion 7a of the switching device 7 includes a first part 7a1, a second part 7a2, and a third part 7a3. The first part 7a1 of the lead portion 7a extends linearly from the main body side of the switching device 7 in a direction parallel to the mounting surface 10a of the radiator 10. The second part 7a2 of the lead portion 7a extends toward a normal direction of the mounting surface 10a such that the second part 7a2 projects from a connecting portion between the first part 7a1 and the second part 7a2 to a position more distant from the radiator 10 than the lower surface 9b which is a surface on the other side of the upper surface 9a of the printed wiring board 9. In this way, the lead portion 7a is bent by 90 degrees from the direction parallel to the mounting surface 10a to the normal direction of the mounting surface 10a at the connecting portion of the first part 7a1 and the second part 7a2. The third part 7a3 of the lead portion 7a extends from a connecting portion between the second part 7a2 and the third part 7a3 in the direction inclined at a predetermined inclination angle (for example, an angle between 5 degrees and 45 degrees, and preferably, an angle between 15 degrees and 30 degrees) relative to the lower surface 9b of the printed wiring board 9, and an end of the third part 7a3 approaches most the lower surface 9b of the printed wiring board 9 or contacts with the lower surface 9b. An end part of the lead portion 7a to which such bending process is applied, namely, an end part of the third part 7a3 extending in the inclination direction is soldered by the solder 19 and connected with the copper foil pattern formed on the lower surface 9b of the printed wiring board 9. The root of the lead portion 7a may be located above the lower surface 9b of the printed wiring board 9 (a position more closer to the lower surface 10a of the radiator 10 than the lower surface 9b of the printed wiring board 9), or the root of the lead portion 7a may be located below the lower surface 9b of the printed wiring board 9 (a position more distant from the lower surface 10a of the radiator 10 than the lower surface 9b of the printed wiring board 9).

By the above configurations of the printed wiring board 9 and the radiator 10, the mounting surface 10a of the radiator 10, which is a contact surface between the switching device 7 and the radiator 10, can be provided at a position close to the printed wiring board 9. Therefore, the length from the lower surface 9b of the printed wiring board 9 to the upper surface (a surface formed by end portions of the radiation fins 10b) of radiator 10 can be shortened. Therefore, slimming or downsizing of the induction heating cooker can be realized. In addition, since a sufficient height of the radiation fins 10b of the radiator 10 can be ensured in a limited space for storing the printed wiring board 9 and the radiator 10, heat radiation efficiency of the switching device 7 is improved. In addition, the bending process is applied to the lead portion 7a of the switching device 7, and the lead portion 7a is connected by soldering with the copper foil pattern formed on the lower surface 9b of the printed wiring board 9. Therefore, thermal stress occurring in the joining portion joining, by the solder 19, between the main body of the switching device 7 and the printed wiring board 9 is reduced by the lead portion 7a having the second part 7a2 and the third part 7a3, and thus occurrence of solder cracking can be prevented. Therefore, reliability against the solder cracking is improved.

In addition, the bending process is applied to the lead portion 7a of the switching device 7 such that the second part 7a2 of the lead portion 7a projects at least once in a direction away from the radiator 10 and then the third part 7a3 extends to close to the lower surface 9b of the printed wiring board 9. Therefore, by the bending process applied to the lead portion 7a, an end position of the lead portion 7a is set to a suitable position without being restricted by a relationship between the position of the root of the lead portion 7a on the switching device 7 and the thickness of the printed wiring board 9. Namely, by the bending process, the distance between the end of the lead portion 7a and the mounting surface 10a of the radiator 10 along the vertical direction (the normal direction of the mounting surface 10a) can be set to become slightly smaller than the thickness of the printed wiring board 9. By such a setting of the end position of the lead portion 7a, when the switching device 7 is mounted to the radiator 10, the end of the lead portion 7a can reliably contact with the lower surface 9b of the printed wiring board 9. In addition, when the lead portion 7a contacts with the lower surface 9b of the printed wiring board 9, repulsive stress applied to the lead portion 7a by the printed wiring board 9 is generated. The lead portion 7a has a spring characteristic, because the bending process is applied to the lead portion 7a so that the lead portion 7a has a portion with a projecting shape which is formed between the second part 7a2 and the third part 7a3, and therefore, the stress applied to the lead portion 7a can be relaxed by the spring characteristic of the lead portion 7a.

In addition, the third part 7a3 of the lead portion 7a of the switching device 7 is inclined at the predetermined inclination angle relative to the lower surface 9b of the printed wiring board 9, and, in this inclined state, the third part 7a3 contacts with the copper foil pattern formed on the lower surface 9b of the printed wiring board 9. Therefore, when the third part 7a3 of the lead portion 7a is soldered to the copper foil pattern, the solder 19 easily enters between the third part 7a3 of the lead portion 7a and the copper foil pattern on the printed wiring board 9. Therefore, soldering between the lead portion 7a and the copper foil pattern can be made with good quality.

The present invention does not rely on the configuration of the inverter circuit 4. Therefore, the present invention is applicable also to a configuration of other inverter circuits which are not described in the first embodiment.

Further, the present invention does not also rely on the type of power semiconductor such as the switching device. Therefore, the present invention is applicable also to other power semiconductors which are not described in the first embodiment.

Furthermore, the shape of the lead portion 7a of the switching device 7 is not limited to the shape, angle, and so on described in the first embodiment. Namely, the shape of the lead portion 7a of the switching device 7 is not limited, provided that the lead portion 7a satisfies a condition such that the lead portion 7a has a projecting part (second part 7a2) which extends and projects in a direction away from the mounting surface 10a of the radiator 10 beyond the lower surface 9b of the printed wiring board 9 and an inclined-and-extending part (third part 7a3) which is inclined at a predetermined inclination angle relative to the lower surface 9b of the printed wiring board 9 and extends from a projecting end of the projecting part to the lower surface 9b of the printed wiring board 9 to contact with the lower surface 9b. In addition, according to Fig. 1, the lead portion 7a of the switching device 7 in the first embodiment has three terminals. Every lead of the lead portion 7a may have a same shape as each other, or some lead(s) of the lead portion 7a may have different shape from the other leads. Namely, if the lead portion 7a has a shape satisfying the above-mentioned condition, the same effect can be obtained.

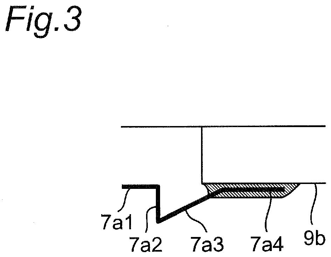

In addition, the lead portion 7a of the switching device 7 may have a shape as shown in Fig. 3, as an example of a configuration such that an end part of the lead portion 7a is inclined and approaches or contacts with the lower surface 9b of the printed wiring board 9. Namely, the lead portion 7a, which has the third part 7a3 approaching the lower surface 9b, may have a fourth part 7a4 further extending from the end part of the third part 7a3 in a direction along the lower surface 9b of the printed wiring board 9. In other words, the lead portion 7a is bent at the end of the third part 7a3 in a direction parallel to the lower surface 9b of the printed wiring board 9, and the lead portion 7a has the fourth part 7a4 further extending from the end in this direction. Since the lead portion 7a has this shape, the area of a proximity region where the fourth part 7a4 of the lead portion 7a and the copper foil pattern exposed on the lower surface 9b of the printed wiring board 9 are close to each other can be increased. Therefore, the fourth part 7a4 of lead portion 7a can be soldered on a large soldering area to the copper foil pattern, and at the same time, a fillet height of the soldering can be ensured at the third part 7a3 of the lead portion 7a. Therefore, it is possible to reduce the connection resistance at the joining part, through which high current flows, between the lead portion 7a and the copper foil pattern and to increase the physical connection strength of the joining portion.

According to the first embodiment, the slots 14 are provided on the mounting surface 10a of the radiator 10 and the fixing-and-supporting members 11 are fixed to the slots 14, and then the fixing-and-supporting members 11 are fixed to the printed wiring board 9 by soldering. Therefore, the radiator 10 does not need to be provided with a screw hole for attaching a screw for fixing the radiator 10 to the printed wiring board 9. As a result, it becomes unnecessary to ensure a through hole on the radiator 10 for such a screw hole. Therefore, limitation on the position where the radiation fins 10b are formed in the radiator 10 can be avoided. In addition, the radiator 10 can be soldered to the copper foil pattern on the printed wiring board 9, simultaneously with the soldering of the other components such as the inverter circuit 4. Therefore, during the assembling, process of turning the printed wiring board 9 over and mounting the radiator 10 to the printed wiring board 9 can be omitted. Therefore, during the assembling, process for mounting the radiator 10 to the printed wiring board 9 can be performed easily.

Further, the eyelets 16 are provided in the mounting holes 15 of the printed wiring board 9 at which the printed wiring board 9 is fixed by soldering to the fixing-and-supporting members 11. Thus, the printed wiring board 9 and the radiator 10 can be fixed more securely. Therefore, even when, for example, an impact is given to the printed wiring board 9 or the radiator 10, a physical load applied to the lead portion 7a of the switching device 7 can be reduced. In addition, in the joining portion providing the connection between the switching device 7 and the printed wiring board 9, overheating caused by increasing of the contact resistance due to generation of a solder crack and so on can be prevented.

When the radiator 10 is manufactured by the extrusion molding process, the radiation fins 10b are formed, and simultaneously the slots 14 for fixing the fixing-and-supporting members 11 are formed on the mounting surface 10a on the lower part of the radiator 10. This configuration of the radiator 10 allows the radiator 10 having the slots 14 to be manufactured easily and at low cost.

### Second Embodiment

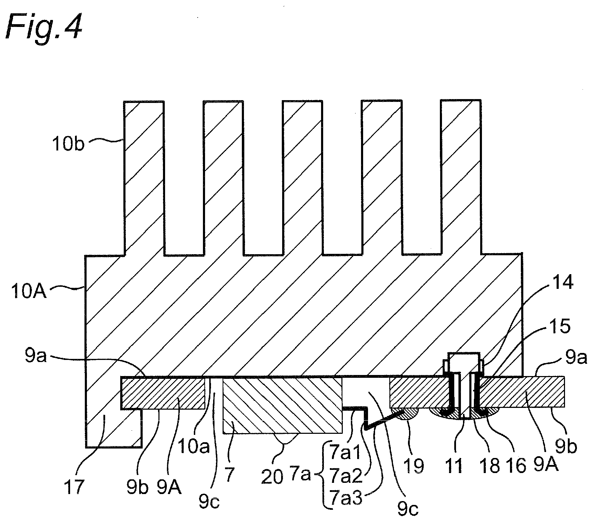

Next, an induction heating cooker according to a second embodiment of the present invention is described as follows. In the following description, descriptions on the same configurations as those of the first embodiment are omitted, and only different configurations are described. Fig. 4 is a longitudinal sectional view showing a neighborhood of the switching device 7 according to the second embodiment of the present invention.

In the induction heating cooker according to the second embodiment, the radiator 10A has a hook part 17 on one end of the radiator 10A, the hook part 17 having a recess with the same width as the thickness of the printed wiring board 9A so as to hook and seize the printed wiring board 9A such that an edge portion of the printed wiring board 9A comes into contact with the hook part 17. The radiator 10A has one slot 14 on another end which is on an opposite side of the above-mentioned one end of the radiator 10A. The edge portion of the printed wiring board 9A contacts with the hook part 17 of the radiator 10A, and the printed wiring board 9A has one mounting hole 15 on the other side of the edge portion of the printed wiring board 9A. In addition, the opening 9c of the printed wiring board 9A is formed between the edge portion and the mounting hole 15.

In the second embodiment, one fixing-and-supporting member 11 is inserted in and fixed to the one slot 14 of the radiator 10A. In addition, one eyelet 16 is inserted in the one mounting hole 15 of the printed wiring board 9A, and one eyelet 16 securely fits into the pin part of the fixing-and-supporting member 11 with a physical fixation. In this way, the one end of radiator 10A and the one edge portion of the printed wiring board 9 are mutually fixed by the hook part 17, and simultaneously the one end of the radiator 10A and the one edge portion of the printed wiring board 9 are mutually fixed by the fixing-and-supporting member 11.

According to the induction heating cooker configured as above, the printed wiring board 9A and the radiator 10A can be mutually fixed more easily and securely. Therefore, even when, for example, an impact is given to the printed wiring board 9A or the radiator 10A, a physical load applied to the lead portion 7a of the switching device 7 can be reduced. Since the radiator 10A can be mounted easily to the printed wiring board 9A, the easiness of assembly of the radiator 10A and printed wiring board 9A can be improved, and the production cost can be reduced.

### Other Embodiments

In the first and second embodiments described above, the radiator (10, 10A) made of aluminum is used, however the radiator is not limited thereto, and the radiator may be made of material having high thermal conductivity, such as aluminum alloy and copper.

In the first and second embodiments, the inverter circuit 4 has a single switching device 7. However, the present invention is not limited thereto, and the inverter circuit 4 may have two or more switching devices. In this case, some or all of the two or more switching devices are mounted on the mounting surface 10a of the radiator (10, 10A) through the opening 9c of the printed wiring board (9, 9A). In addition, in this case, the opening 9c of the printed wiring board may include a plurality of openings.

In the first and second embodiments, only the switching device 7 is mounted on the mounting surface 10a of the radiator (10, 10A) through the opening 9c of the printed wiring board (9, 9A). However, the present invention is not limited thereto, and other components (for example, the rectifier circuit 2) may be mounted on the mounting surface 10a of the radiator through the opening 9c.

In the embodiments 1 and 2, the shape and position of the opening 9c of the printed wiring board (9, 9A) are not limited. The opening 9c may be, for example, formed at a center of the printed wiring board or at a position different from the center, and the opening 9c may have, for example, a rectangular shape. Alternatively, a notch may be formed on an edge portion of the printed wiring board such that, for example, an opening is formed on the printed wiring board and one or two sides of the opening open.

### INDUSTRIAL APPLICABILITY

As described above, the present invention can achieve both an improvement of the cooling efficiency of the switching device and a downsizing of the induction heating cooker, and therefore, the present invention is applicable to induction heating cookers and all other electric apparatuses which have a device generating heat, such as a switching device, and a radiator for cooling the device generating heat.

## Claims

1. An induction heating cooker comprising:
a heating coil (5);
an inverter circuit (4) having a switching device (7), the inverter circuit (4) performing on-off control of the switching device (7) to supply high frequency current to the heating coil (5);
a radiator (10; 10A) having a mounting surface (10a) on which the switching device (7) is mounted; and
a printed wiring board (9; 9A) on which components included in the inverter circuit (4) are arranged, wherein
the radiator (10; 10A) is mounted on a surface on one side of the printed wiring board (9; 9A),
**characterized in that** the printed wiring board (9; 9A) has an opening larger than a main body of the switching device (7), the main body being a part of the switching device (7) excluding a lead portion (7a) of the switching device (7),
the switching device (7) is mounted on the mounting surface (10a) of the radiator (10; 10A) through the opening of the printed wiring board (9; 9A), and
the lead portion (7a) comprises
an extending part which linearly extends from the main body of the switching device (7) in a direction substantially parallel to the mounting surface (10a) of the radiator (10; 10A),
a projecting part (7a2) which extends and projects in a direction away from the mounting surface (10a) of the radiator (10; 10A) beyond a root of the lead portion (7a) on the main body of the switching device (7) and beyond another surface on the other side of the printed wiring board (9; 9A) different from the surface on the one side of the printed wiring board (9; 9A), and
an inclined-and-extending part (7a3) which is inclined at a predetermined inclination angle relative to the other surface of the printed wiring board (9; 9A) and extends from a projecting end of the projecting part (7a2) to the other surface of the printed wiring board (9; 9A).

2. The induction heating cooker as claimed in claim 1, wherein
a fixing-and-supporting member (11) for fixing the radiator (10; 10A) to the printed wiring board (9; 9A) and supporting the radiator (10; 10A) is attached to the radiator (10; 10A) such that a part of the fixing-and-supporting member (11) projects from the mounting surface (10a) of the radiator (10; 10A),
the printed wiring board (9; 9A) has a mounting hole (15) formed for allowing the fixing-and-supporting member (11) to penetrate the mounting hole (15) when the radiator (10; 10A) is mounted to the printed wiring board (9; 9A), and
an end part of the fixing-and-supporting member (11) is fixed by soldering to the other surface of the printed wiring board (9; 9A) in a state that the fixing-and-supporting member (11) penetrates the mounting hole (15).

3. The induction heating cooker as claimed in claim 2, further comprising
an eyelet (16) attached to the mounting hole (15) of the printed wiring board (9; 9A), the eyelet (16) being formed such that the fixing-and-supporting member (11) fits into the eyelet (16).

4. The induction heating cooker as claimed in claim 2 or 3, wherein
the radiator (10; 10A) further comprising
radiation fins (10b) including a plurality of plates formed parallel to each other, each of the radiation fins (10b) having a fin-shape extending in a direction parallel to the mounting surface (10a), and
a slot (14) formed on the mounting surface (10a) such that the slot (14) extends in the direction parallel to the mounting surface (10a).

5. The induction heating cooker according to any one of claims 2 to 4, wherein
the radiator (10; 10A) has a hook part (17) formed on one end thereof for hooking and seizing the printed wiring board (9; 9A) such that an edge portion of the printed wiring board (9; 9A) comes into contact with the hook part (17),
and the radiator (10; 10A) is fixed, at another end different from the one end of the radiator (10; 10A), to the printed wiring board (9; 9A) by the fixing-and-supporting member (11).

## Patentansprüche

1. Induktionsherd, umfassend:
eine Heizspule (5);
eine Inverterschaltung (4) mit einer Schaltvorrichtung (7), wobei die Inverterschaltung (4) eine Ein/Aus-Steuerung der Schaltvorrichtung (7) durchführt, um die Heizspule (5) mit Hochfrequenzstrom zu versorgen;
einen Kühlkörper (10; 10A) mit einer Montagefläche (10a), auf die die Schaltvorrichtung (7) montiert ist; und
eine Leiterplatte (9; 9A), auf der Bauteile angeordnet sind, die in der Inverterschaltung (4) enthalten sind, wobei
der Kühlkörper (10; 10A) auf eine Oberfläche auf einer Seite der Leiterplatte (9; 9A) montiert ist,
**dadurch gekennzeichnet, dass** die Leiterplatte (9; 9A) eine Öffnung hat, die größer als ein Hauptkörper der Schaltvorrichtung (7) ist, wobei der Hauptkörper ein Teil der Schaltvorrichtung (7) ohne einen Leitungsabschnitt (7a) der Schaltvorrichtung (7) ist,
die Schaltvorrichtung (7) durch die Öffnung der Leiterplatte (9; 9A) auf die Montagefläche (10a) des Kühlkörpers (10; 10A) montiert ist, und
der Leitungsabschnitt (7a) umfasst:
einen sich erstreckenden Teil, der sich linear vom Hauptkörper der Schaltvorrichtung (7) in eine im Wesentlichen parallele Richtung zur Montagefläche (10a) des Kühlkörpers (10; 10A) erstreckt,
einen vorstehenden Teil (7a2), der sich in eine Richtung weg von der Montagefläche (10a) des Kühlkörpers (10; 10A) über eine Wurzel des Leitungsabschnitts (7a) auf dem Hauptkörper der Schaltvorrichtung (7) hinaus und über eine andere Oberfläche auf der anderen Seite der Leiterplatte (9; 9A), die von der Oberfläche auf der einen Seite der Leiterplatte (9; 9A) verschieden ist, hinaus erstreckt und in diese Richtung vorsteht, und
einen geneigten und sich erstreckenden Teil (7a3), der in einem vorbestimmten Neigungswinkel relativ zu der anderen Oberfläche der Leiterplatte (9; 9A) geneigt ist und sich von einem vorstehenden Ende des vorstehenden Teils (7a2) zu der anderen Oberfläche der Leiterplatte (9; 9A) erstreckt.

2. Induktionsherd nach Anspruch 1, wobei
ein Befestigungs- und Tragelement (11) zum Befestigen des Kühlkörpers (10; 10A) an der Leiterplatte (9; 9A) und zum Tragen des Kühlkörpers (10; 10A) an dem Kühlkörper (10; 10A) derart angebracht ist, dass ein Teil des Befestigungs- und Tragelements (11) von der Montagefläche (10a) des Kühlkörpers (10; 10A) vorsteht,
die Leiterplatte (9; 9A) eine Montagebohrung (15) aufweist, die so ausgebildet ist, dass das Befestigungs- und Tragelement (11) die Montagebohrung (15) durchdringen kann, wenn der Kühlkörper (10; 10A) an die Leiterplatte (9; 9A) montiert ist, und
ein Endteil des Befestigungs- und Tragelements (11) durch Löten in einem solchen Zustand an der anderen Oberfläche der Leiterplatte (9; 9A) befestigt ist, dass das Befestigungs- und Tragelement (11) die Montagebohrung (15) durchdringt.

3. Induktionsherd nach Anspruch 2, ferner umfassend
eine Öse (16), die an der Montagebohrung (15) der Leiterplatte (9; 9A) befestigt ist, wobei die Öse (16) derart geformt ist, dass das Befestigungs- und Tragelement (11) in die Öse (16) passt.

4. Induktionsherd nach Anspruch 2 oder 3, wobei
der Kühlkörper (10; 10A) ferner umfasst:
Kühlrippen (10b), die eine Vielzahl von parallel zueinander ausgebildeten Platten umfassen, wobei jede der Kühlrippen (10b) eine Rippenform aufweist, die sich in eine zur Montagefläche (10a) parallele Richtung erstreckt, und
einen Schlitz (14), der auf der Montagefläche (10a) derart ausgebildet ist, dass sich der Schlitz (14) in der zur Montagefläche (10a) parallelen Richtung erstreckt.

5. Induktionsherd nach einem der Ansprüche 2 bis 4, wobei
der Kühlkörper (10; 10A) einen Hakenteil (17) aufweist, der auf einem Ende desselben ausgebildet ist, um die Leiterplatte (9; 9A) derart einzuhaken und zu ergreifen, dass ein Randabschnitt der Leiterplatte (9; 9A) in Kontakt mit dem Hakenteil (17) kommt,
und wobei der Kühlkörper (10; 10A) an einem anderen Ende, das von dem einen Ende des Kühlkörpers (10; 10A) verschieden ist, mit dem Befestigungs- und Tragelement (11) an der Leiterplatte (9; 9A) befestigt ist.

## Revendications

1. Cuisinière à chauffage par induction comprenant:
une bobine de chauffage (5);
un circuit inverseur (4) ayant un dispositif de commutation (7), le circuit inverseur (4) effectuant la commande marche-arrêt du dispositif de commutation (7) pour alimenter un courant haute fréquence à la bobine de chauffage (5);
un radiateur (10; 10A) ayant une surface de montage (10a) sur laquelle est monté le dispositif de commutation (7); et
une carte à circuit imprimé (9; 9A) sur laquelle sont disposés les composants inclus dans le circuit inverseur (4), dans lequel
le radiateur (10; 10A) est monté sur une surface sur un côté de la carte à circuit imprimé (9; 9A),
**caractérisé en ce que** la carte à circuit imprimé (9; 9A) a une ouverture plus grande qu'un corps principal du dispositif de commutation (7), le corps principal faisant partie du dispositif de commutation (7) à l'exception d'une partie avant (7a) du dispositif de commutation (7),
le dispositif de commutation (7) est monté sur la surface de montage (10a) du radiateur (10; 10A) à travers l'ouverture de la carte à circuit imprimé (9; 9A), et
la partie avant (7a) comprend
une partie en extension qui s'étend linéairement à partir du corps principal du dispositif de commutation (7) dans une direction sensiblement parallèle à la surface de montage (10a) du radiateur (10; 10A),
une partie faisant saillie (7a2) qui s'étend et fait saillie dans une direction à l'écart de la surface de montage (10a) du radiateur (10; 10A) au-delà d'une origine de la partie avant (7a) sur le corps principal du dispositif de commutation (7) et au-delà d'une autre surface sur l'autre côté de la carte à circuit imprimé (9; 9A) différente de la surface sur le premier côté de la carte à circuit imprimé (9; 9A), et
une partie inclinée et en extension (7a3) qui est inclinée selon un angle d'inclinaison prédéterminé par rapport à l'autre surface de la carte à circuit imprimé (9; 9A) et s'étend à partir d'une extrémité faisant saillie de la partie faisant saillie (7a2) jusqu'à l'autre surface de la carte à circuit imprimé (9; 9A).

2. Cuisinière à chauffage par induction selon la revendication 1, dans lequel
un élément de fixation et de support (11) destiné à fixer le radiateur (10; 10A) à la carte à circuit imprimé (9; 9A) et à supporter le radiateur (10; 10A) est attaché au radiateur (10; 10A) de telle sorte qu'une partie de l'élément de fixation et de support (11) fait saillie depuis la surface de montage (10a) du radiateur (10; 10A),
la carte à circuit imprimé (9; 9A) a un trou de montage (15) formé pour permettre à l'élément de fixation et de support (11) de pénétrer dans le trou de montage (15) lorsque le radiateur (10; 10A) est monté sur la carte à circuit imprimé (9; 9A), et
une partie d'extrémité de l'élément de fixation et de support (11) est fixée par soudure à l'autre surface de la carte à circuit imprimé (9; 9A) dans un état dans lequel l'élément de fixation et de support (11) pénètre dans le trou de montage (15).

3. Cuisinière à chauffage par induction selon la revendication 2, comprenant en outre
un oeillet (16) attaché au trou de montage (15) de la carte à circuit imprimé (9; 9A), l'oeillet (16) étant formé de telle sorte que l'élément de fixation et de support (11) s'ajuste dans l'oeillet (16).

4. Cuisinière à chauffage par induction selon la revendication 2 ou 3, dans lequel
le radiateur (10; 10A) comprend en outre
des ailettes de rayonnement (10b) incluant une pluralité de plaques formées parallèles les unes aux autres, chacune des ailettes de rayonnement (10b) ayant une forme d'ailette s'étendant dans une direction parallèle à la surface de montage (10a), et
une fente (14) formée sur la surface de montage (10a) de telle sorte que la fente (14) s'étend dans la direction parallèle à la surface de montage (10a).

5. Cuisinière à chauffage par induction selon l'une quelconque des revendications 2 à 4, dans lequel
le radiateur (10; 10A) a une partie de crochet (17) formée sur une extrémité de celui-ci pour l'accrochage et la saisie de la carte à circuit imprimé (9; 9A) de telle sorte qu'une partie de bord de la carte à circuit imprimé (9; 9A) vient en contact avec la partie de crochet (17),
et le radiateur (10; 10A) est fixé, au niveau d'une autre extrémité différente de la première extrémité du radiateur (10; 10A), à la carte à circuit imprimé (9; 9A) par l'élément de fixation et de support (11).
